# FASCICULE DE BREVET EUROPEEN

(11) **EP 2 612 359 B1**
(45) Date de publication et mention de la délivrance du brevet: **27.02.2019**
(21) Numéro de dépôt: 11752526.1
(22) Date de dépôt: 31.08.2011
(51) Int. Cl.: H01L 27/22, G11C 11/16, H01F 10/32, H01L 43/08

(54) **DISPOSITIF MAGNETIQUE ET PROCEDES DE LECTURE ET D'ECRITURE DUDIT DISPOSITIF**
MAGNETVORRICHTUNG UND VERFAHREN ZUM LESEN VON UND SCHREIBEN AUF DIESER VORRICHTUNG
MAGNETIC DEVICE, AND METHOD FOR READING FROM AND WRITING TO SAID DEVICE

(30) Priorité: 01.09.2010 FR 1056950
(43) Date de publication de la demande: 10.07.2013
(73) Titulaire: Commissariat à l'Énergie Atomique et aux Énergies Alternatives, 75015 Paris (FR)
(72) Inventeur: DIENY, Bernard, F-38250 Lans En Vercors (FR)
(74) Mandataire: Lebkiri, Alexandre
(86) Numéro de dépôt international: PCT/EP2011/065057
(87) Numéro de publication internationale: WO 2012/028664

(56) Documents cités:
- WO-A1-2010/064476
- US-A1- 2006 087 880
- US-A1- 2010 110 783
- SOUSA R C ET AL: "Non-volatile magnetic random access memories (MRAM)", COMPTES RENDUS - PHYSIQUE, ELSEVIER, PARIS, FR, vol. 6, no. 9, 1 novembre 2005 (2005-11-01), pages 1013-1021, XP025360317, ISSN: 1631-0705 [extrait le 2005-11-01]

## Description

La présente invention concerne un dispositif magnétique et un procédé de lecture et d'écriture dans un tel dispositif magnétique.

L'invention trouve une application en électronique et notamment dans la réalisation de points mémoire et de mémoire de type MRAM (« Magnetic Random Access Memory » ou mémoire magnétique à accès direct).

Les mémoires magnétiques MRAM ont connu un regain d'intérêt avec la mise au point de jonctions tunnels magnétiques présentant une forte magnétorésistance à température ambiante. Les mémoires MRAM comportent plusieurs points mémoires. Ces points mémoires sont généralement des dispositifs magnétiques qui comportent :
- une couche magnétique appelée « couche de référence » qui présente une aimantation dont la direction est fixe ;
- une couche magnétique appelée « couche de stockage » qui présente une aimantation dont la direction est variable et qui peut s'orienter soit parallèlement, soit antiparallèlement à la direction d'aimantation de la couche de référence ;
- une couche d'isolation ou semi-conductrice qui sépare la couche de référence et la couche de stockage.

Le document FR2817999 décrit un tel dispositif magnétique. Ce dispositif magnétique présente deux modes de fonctionnement : un mode « lecture » et un mode « écriture ». Lors du mode écriture, un courant électrique, de tension d'écriture supérieure à une tension critique, est envoyé à travers les couches, de façon à ce qu'il traverse les couches soit dans un sens, soit dans le sens opposé. Ce courant électrique provoque le retournement de la direction d'aimantation de la couche de stockage, qui devient alors parallèle ou antiparallèle à la direction d'aimantation de la couche de référence. Suivant que la direction d'aimantation de la couche de stockage est parallèle ou antiparallèle à la direction d'aimantation de la couche de référence, un « 1 » ou un « 0 » est stocké dans la couche de stockage.

Lors du mode lecture, on injecte un autre courant électrique à travers le dispositif. Ce courant électrique doit avoir une tension de lecture strictement inférieure à la tension d'écriture. Ce courant électrique permet de mesurer la résistance du dispositif magnétique. Lorsque les directions d'aimantation de la couche de référence et de la couche de stockage sont parallèles, la résistance de la jonction est faible, tandis que lorsque les directions d'aimantation des couches de référence et de stockage sont antiparallèles, la résistance de la jonction est élevée. Par comparaison avec une résistance de référence, la valeur stockée dans la couche de stockage (« 0 » ou « 1 ») peut être déterminée.

Le document FR2817999 propose par ailleurs d'utiliser comme couche de stockage un empilement tricouche constitué par deux couches magnétiques à aimantations antiparallèles séparées par une couche conductrice non magnétique.

Toutefois, ce dispositif magnétique présente plusieurs inconvénients. Tout d'abord, ce dispositif présente une tension de claquage au-delà de laquelle il est endommagé. Lors de l'écriture, la tension d'écriture doit donc rester inférieure à la tension de claquage.

Par ailleurs, la tension de lecture doit rester très inférieure à la tension d'écriture pour ne pas risquer de modifier la direction d'aimantation de la couche de stockage lors de la lecture. Toutefois, on ne peut pas utiliser une tension de lecture trop faible car sinon on diminue la vitesse de lecture.

Il est donc difficile de choisir des tensions de lecture et d'écriture suffisamment inférieures à la tension de claquage et suffisamment distinctes entre elles pour ne risquer d'écrire au lieu de lire, sans toutefois trop diminuer la vitesse de lecture.

Le document FR2832542 décrit également un dispositif magnétique à jonction tunnel magnétique, ainsi que des procédés de lecture et d'écriture utilisant ce dispositif. Ce dispositif comporte une couche de référence, présentant une aimantation de direction fixe, une couche de stockage, présentant une aimantation dont la direction est variable et une couche polarisante supplémentaire dont la direction d'aimantation est fixe et antiparallèle à la direction d'aimantation de la couche de référence. Cette couche polarisante supplémentaire permet de renforcer le transfert de spin sur la couche de stockage lors de l'écriture puisqu'elle permet de cumuler le courant d'électrons à spin polarisé provenant de la couche de référence et le courant d'électrons à spin polarisé provenant de la couche polarisante supplémentaire.

Toutefois, comme dans le document FR2817999, ce dispositif magnétique présente un risque d'écriture accidentelle lors de la lecture, puisque le courant d'électrons permettant de lire l'information dans la couche de stockage peut modifier accidentellement la direction d'aimantation de la couche de stockage et ainsi modifier l'information contenue dans la couche de stockage.

SOUSA R C ET AL: "Non-volatile magnetic random access memories (MRAM)", Comptes rendus physique, ELSEVIER, PARIS, FR, vol. 6, no. 9, 1 novembre 2005, pages 1013-1021, ISSN: 1631-0705 défini plusieurs stratégies d' écriture pour les mémoires MRAM : Astroide des champs hard axis - easy axis - et de la saturation, assistance thermique, changement précessionnel de magnétisation d' une couche de contrôle ("soft layer"), changement de magnétisation de précession en régime permanent d' une couche fine de contrôle par courant de polarisation induit avant écriture.

L'invention vise à remédier, au moins partiellement, aux inconvénients de l'état de la technique en proposant un dispositif magnétique qui permet d'utiliser des tensions de lecture et d'écriture comparables, sans risquer d'écrire involontairement au moment de la lecture.

L'invention vise donc à proposer un dispositif magnétique permettant de s'affranchir du problème de devoir séparer les distributions de tension d'écriture et de tension de lecture.

Pour ce faire, est proposé selon un premier aspect de l'invention, un dispositif magnétique comportant :
- une première couche magnétique dite « couche de référence » ayant une aimantation de direction fixe ;
- une deuxième couche magnétique dite « couche de stockage » ayant une aimantation de direction variable, l'aimantation de la couche de stockage pouvant être parallèle ou antiparallèle à l'aimantation de la couche de référence ;
- un premier espaceur séparant la couche de référence et la couche de stockage ;
ledit dispositif étant caractérisé en ce qu'il comporte en outre :
- une troisième couche magnétique dite « couche de contrôle » ayant une aimantation de direction variable, l'aimantation de la couche de contrôle pouvant être sensiblement parallèle ou antiparallèle à l'aimantation de la couche de référence ;
- un deuxième espaceur séparant la couche de stockage et la couche de contrôle ;
- des moyens de contrôle de la direction de l'aimantation de la couche de contrôle aptes à modifier la direction de l'aimantation de la couche de contrôle sans modifier la direction de l'aimantation de la couche de stockage.

Ainsi, l'invention permet d'utiliser des tensions d'écriture et de lecture comparables sans risque d'écrire pendant la lecture en modulant l'efficacité du transfert de spin entre la lecture et l'écriture par l'orientation de la couche de contrôle. Ceci évite de devoir lire à des tensions très basses, c'est-à-dire inférieures à 0.1V, qui ralentissent considérablement la lecture.

Ainsi, le dispositif magnétique selon l'invention est particulièrement remarquable en ce qu'il comporte, outre les couches de stockage et de référence, une couche de contrôle dont la direction d'aimantation est variable. La direction d'aimantation de cette couche de contrôle pourra ainsi être choisie :
- soit pour augmenter l'efficacité du transfert de spin entre un courant d'électrons injecté à travers les couches et la couche de stockage, lorsque l'on veut écrire dans la couche de stockage ;
- soit pour diminuer l'efficacité du transfert de spin lorsque l'on veut seulement lire l'information contenue dans la couche de stockage, sans risquer de modifier cette information.

Ainsi, préalablement à toute lecture ou écriture, la direction d'aimantation de la couche de contrôle sera choisie de façon à augmenter l'efficacité du transfert de spin ou à la diminuer.

Plus précisément, le dispositif magnétique selon l'invention peut donc fonctionner de la manière suivante. En écriture, la direction d'aimantation de la couche de contrôle est choisie de façon à favoriser le transfert de spin. Cette orientation de l'aimantation de la couche de contrôle augmentant l'efficacité du transfert de spin est sensiblement antiparallèle à l'aimantation de la couche de référence. Lorsque l'on veut écrire dans la couche de stockage, on envoie un courant d'électrons à travers les couches, perpendiculairement aux couches. Ce courant d'électrons traverse le dispositif de part en part. Supposons, dans la discussion qui suit, que les électrons circulent de la couche de référence vers la couche de stockage, c'est-à-dire que le courant électrique circule de la couche de stockage vers la couche de référence. Lorsque ce courant d'électrons traverse la couche de référence, qui est aimantée dans une direction fixe, les spins des électrons vont se trouver polarisés suivant l'aimantation de la couche de référence du fait de la structure électronique du matériau magnétique constituant la couche de référence. De ce fait, les électrons sortiront de la couche de référence avec un spin polarisé. Lorsque ces électrons traversent la couche de stockage, ils vont exercer un couple de transfert de spin sur l'aimantation de la couche de stockage qui va tendre à aligner l'aimantation de la couche de stockage parallèlement au moment magnétique de la couche de référence. Ainsi, la couche de référence va favoriser l'alignement parallèle de l'aimantation de la couche de stockage pour ce sens du courant. En outre, puisque pour l'écriture la direction d'aimantation de la couche de contrôle a été choisie pour augmenter l'efficacité du transfert de spin entre la couche de référence et la couche de stockage, les électrons de spin minoritaire (c'est-à-dire de spin opposé à l'aimantation de la couche de contrôle) vont être réfléchis vers la couche de stockage. Ces électrons réfléchis qui ont un spin antiparallèle à l'aimantation de la couche de contrôle, donc parallèle à l'aimantation de la couche de référence, vont eux aussi exercer un couple de transfert de spin favorisant l'alignement parallèle des aimantations des couches de stockage et de référence. On comprend ainsi que l'alignement antiparallèle des aimantations des couches de référence et de contrôle permet de bénéficier d'un renforcement de l'efficacité du transfert de spin, et donc facilite l'écriture par courant de la couche de stockage.

Si maintenant la direction du courant est inversée, les transferts de spin exercés par les électrons arrivant directement de la couche de contrôle et des électrons réfléchis par la couche de référence vont se cumuler pour favoriser l'alignement antiparallèle de l'aimantation de la couche de stockage et de la couche de référence. Ainsi suivant la direction du courant on pourra écrire soit la configuration parallèle (par configuration, on entend alignement relatif des aimantations de la couche de référence et de celle de la couche de stockage), soit la configuration antiparallèle. Dans le cas de l'écriture, les couches de référence et de contrôle coopèrent donc pour favoriser le changement de la direction d'aimantation de la couche de stockage. Le transfert de spin dû à la couche de référence et le transfert de spin dû à la couche de contrôle sont donc cumulatifs en écriture.

La couche de contrôle permet donc, en écriture, de cumuler le couple de transfert de spin dû au courant d'électrons à spin polarisé provenant de la couche de référence avec le couple de transfert de spin dû au courant d'électrons à spin polarisé provenant de la couche de contrôle. La tension d'écriture peut donc être inférieure à celle utilisée dans les dispositifs de l'art antérieur puisque l'effet de transfert de spin entre le courant électrique et la couche de stockage est maximisé par la présence de la couche de contrôle.

En mode lecture au contraire, la direction de l'aimantation de la couche de contrôle est choisie de façon sensiblement parallèle à celle de la couche de référence. À ce moment-là, les effets de transfert de spin produits par la couche de référence et la couche de contrôle se soustraient. En effet, lorsque le courant de lecture circule à travers la structure, les électrons directs provenant de la couche de référence et les électrons réfléchis provenant de la couche de contrôle ont des polarisations en spin opposées, provoquant une diminution de l'efficacité du transfert de spin. Il en est de même quel que soit le sens du courant de lecture. La couche de contrôle permet donc, en lecture, de compenser au moins partiellement le couple de transfert de spin dû au courant d'électrons à spin polarisé provenant de la couche de référence par celui dû au courant d'électrons à spin polarisé provenant de la couche de contrôle. Ainsi, en mode lecture, la direction d'aimantation de la couche de contrôle est choisie de façon à ce que la couche de contrôle tende à orienter la direction d'aimantation de la couche de stockage dans un sens, tandis que la couche de référence tend à orienter la direction d'aimantation de la couche de stockage dans le sens opposé. Ainsi, le courant d'électrons qui traverse les couches ne modifie pas la direction d'aimantation de la couche de stockage.

Le dispositif d'aimantation selon l'invention permet donc d'utiliser des courants électriques de tension comparables en lecture et en écriture, sans pour autant risquer d'écrire lors de la lecture.

Selon l'invention, la couche de contrôle permet donc de sélectionner soit le mode écriture ou soit le mode lecture. La direction d'aimantation de la couche de contrôle est donc modifiée selon l'invention uniquement lorsque l'on veut passer du mode lecture au mode écriture ou inversement. Par conséquent, si on fait des écritures successives, sans lecture entre deux écritures, on ne modifie pas l'aimantation de la couche de contrôle quelle que soit l'état logique que l'on veut écrire. De même si après une écriture on effectue plusieurs lectures successives, sans écriture entre ces lectures successives, on ne modifie pas l'aimantation de la couche de contrôle entre chaque événement de lecture. Une fois qu'un mode lecture ou écriture a été choisi, l'aimantation de la couche de contrôle reste fixe pendant tous les événements d'écriture successifs ou tous les événements de lecture successifs.

La direction de l'aimantation de la couche de contrôle selon l'invention est donc modifiée uniquement en fonction du mode lecture ou écriture dans lequel on veut se placer, et non pas de l'état logique que l'on veut mettre en mémoire dans la couche de stockage. Par ailleurs, une fois que l'on a fait commuter l'aimantation de la couche de contrôle pour passer d'un mode à l'autre, son aimantation devient piégée pendant toutes les écritures successives tant que ces écritures ne sont pas interrompues par une lecture. La couche de contrôle est donc réalisée dans un matériau dont la direction d'aimantation ne peut pas être modifiée trop facilement, comme ce serait le cas pour un matériau ferromagnétique doux.

En outre, la couche de contrôle selon l'invention facilite la lecture puisque les effets de magnétorésistance provenant de la jonction tunnel formée par l'ensemble couche de référence/barrière tunnel/couche de stockage et couche de stockage/deuxième espaceur/couche de contrôle s'ajoutent à la lecture.

Le dispositif magnétique selon l'invention peut également présenter une ou plusieurs des caractéristiques ci-dessous, considérées individuellement ou selon toutes les combinaisons techniquement possibles.

Avantageusement, chaque espaceur est constitué d'un matériau isolant ou semi-conducteur.

Par ailleurs, la direction de l'aimantation de la couche de stockage d'une part et la direction de l'aimantation de la couche de contrôle d'autre part doivent pouvoir être contrôlées séparément l'une de l'autre, sans que la modification d'une de ces directions d'aimantation ne modifie l'autre de ces directions d'aimantation.

En particulier, la direction d'aimantation de la couche de stockage doit pouvoir être commutée, sans que la direction d'aimantation de la couche de contrôle ne varie, et vice versa.

Pour cela, la direction d'aimantation de la couche de stockage et la direction d'aimantation de la couche de contrôle seront modifiées par des procédés différents. Par exemple, la direction d'aimantation de la couche de stockage sera modifiée par transfert de spin à l'aide d'un courant circulant perpendiculairement au plan des couches alors que la direction d'aimantation de la couche de contrôle sera modifiée par champ magnétique ou par propagation de parois parallèlement au plan des couches.

Selon un mode de réalisation préférentiel, la couche de stockage est formée d'un premier empilement tri-couche dit « antiferromagnétique synthétique » constitué de deux couches magnétiques séparées par une couche conductrice non magnétique, les deux couches magnétiques étant couplées antiparallèlement à travers la couche conductrice non magnétique. Cet empilement tricouche antiferromagnétique synthétique est de préférence constitué de deux couches magnétiques, typiquement en CoFe ou CoFeB, séparées par une couche conductrice non magnétique, typiquement en ruthenium Ru d'épaisseur de préférence comprise entre 0.5 nm et 0.9 nm. Dans ce mode de réalisation, les deux couches magnétiques de l'empilement tricouche antiferromagnétique synthétique présentent un couplage magnétique antiparallèle à travers la couche conductrice non magnétique. Selon l'invention, les moments magnétiques des deux couches magnétiques de l'empilement tricouche antiferromagnétique synthétique sont avantageusement choisis sensiblement égaux de sorte que le moment total de l'empilement tricouche antiferromagnétique synthétique soit proche de zéro, typiquement que le moment total soit une fraction de moins de 30% du moment d'une des deux couches ferromagnétiques constitutives et de façon préférable de moins de 15%.

Dans ce document, on appelle « moment magnétique » d'une couche magnétique le moment magnétique d'une couche magnétique par unité de surface, c'est-à-dire le produit de l'aimantation de la couche magnétique multipliée par l'épaisseur de cette couche magnétique.

Ce mode de réalisation est avantageux car il permet d'avoir une aimantation plus uniforme et il permet d'avoir une plus grande stabilité thermique puisque le volume de la couche de stockage est plus important. Il est connu que la direction d'aimantation d'un tel empilement tricouche peut être modifiée par transfert de spin, c'est-à-dire que les aimantations des couches magnétiques qui constituent l'empilement tricouche, tout en restant antiparallèles entre elles, peuvent être commutées d'une direction à la direction opposée sous l'effet d'un courant polarisé en spin traversant la structure. Par contre, comme cet empilement tricouche présente un moment magnétique globalement quasi nul, il réagira très peu à un champ magnétique. Comme nous allons le voir plus loin, en choisissant une couche de contrôle constituée d'une simple couche magnétique, on va pouvoir ainsi retourner l'aimantation de la couche de contrôle par champ magnétique, puisque son moment magnétique est non nul, sans retourner l'aimantation de l'empilement tricouche dont le moment est quasiment nul.

Lorsque la couche de stockage est formée par un empilement tricouche, la direction d'aimantation de la couche de contrôle est de préférence contrôlée de façon à ce que, en mode écriture, la couche de contrôle présente une direction d'aimantation parallèle à la direction d'aimantation de la couche de référence. Ainsi, le transfert de spin dû à la couche de référence et le transfert de spin dû à la couche de contrôle sont cumulatifs au niveau de l'ensemble de l'empilement tricouche qui forme la couche de stockage. Au contraire, en mode lecture, la direction d'aimantation de la couche de contrôle est de préférence contrôlée de façon à ce que la couche de contrôle présente une direction d'aimantation antiparallèle à la direction d'aimantation de la couche de référence. Ainsi, les transferts de spin dû à la couche de référence et à la couche de contrôle s'annulent.

Selon un autre mode de réalisation, la couche de stockage est formée d'une monocouche en matériau magnétique.

Dans ce cas, la direction d'aimantation de la couche de contrôle est contrôlée de façon à ce que, en mode écriture, elle soit antiparallèle à la direction d'aimantation de la couche de référence. Ainsi, en mode écriture, les transferts de spins dus à la couche de contrôle et à la couche de référence sont cumulatifs. Au contraire, en mode lecture, la direction d'aimantation dans la couche de contrôle est choisie de façon à ce qu'elle soit parallèle à la direction d'aimantation de la couche de référence, de façon à ce que les transferts de spin dus à la couche de contrôle et à la couche de référence se compensent.

Avantageusement, la couche de contrôle est formée d'une monocouche en matériau magnétique.

Selon l'invention, la direction de l'aimantation de la couche de contrôle doit pouvoir être modifiée, sans modifier la direction d'aimantation de la couche de stockage. Pour cela, les moyens de contrôle de la direction de l'aimantation de la couche de contrôle doivent être aptes à modifier la direction de l'aimantation de la couche de contrôle sans modifier la direction de l'aimantation de la couche de stockage.

Selon un mode de réalisation, les moyens de contrôle de la direction de l'aimantation de la couche de contrôle comportent des moyens de génération d'un champ magnétique de direction parallèle ou antiparallèle à la direction de l'aimantation de la couche de référence. Ce mode de réalisation est particulièrement avantageux lorsque la couche de stockage est formée d'un empilement tricouche antiferromagnétique synthétique comportant deux couches magnétiques couplées antiparallèlement à travers une couche conductrice non magnétique. En effet, dans ce cas, les couches magnétiques de l'empilement tricouche présentent de préférence des aimantations qui se compensent et, par conséquent, le champ magnétique n'a quasiment pas d'influence sur la couche de stockage. Par conséquent, les directions d'aimantations des couches magnétiques qui forment la couche de stockage ne varient pas. Par contre, la couche de contrôle, qui est seule, est sensible au champ magnétique, si bien que son aimantation change de direction sous l'effet d'un champ magnétique.

Les moyens de génération d'un champ magnétique peuvent comporter au moins un conducteur qui est parcouru par un courant dans un sens ou dans l'autre de façon à créer un champ magnétique parallèle ou antiparallèle à la direction d'aimantation de la couche de référence.

Lorsque les couches de contrôle, de stockage et de référence sont polarisées dans le plan dans lequel elles se trouvent, par exemple lorsque ces couches s'étendent suivant une direction longitudinale et que leurs directions d'aimantation sont parallèles ou antiparallèles à cette direction d'aimantation, les moyens de contrôle comportent de préférence un conducteur qui s'étend parallèlement au plan dans lequel se trouvent les couches de contrôle, de stockage et de référence et qui est aligné, suivant la direction longitudinale, avec les couches de contrôle, de stockage et de référence. De cette façon, le courant qui traverse le premier conducteur permet de créer un champ magnétique qui est parallèle ou antiparallèle à la direction d'aimantation de la couche de contrôle.

Par contre, lorsque les couches de contrôle, de stockage et de référence sont polarisées hors du plan dans lequel elles se trouvent, par exemple lorsque ces couches s'étendent suivant une direction longitudinale et que leurs directions d'aimantation sont parallèles ou antiparallèles à une direction transversale perpendiculaire à cette direction longitudinale, les moyens de contrôle comportent de préférence deux conducteurs qui s'étendent chacun parallèlement au plan dans lequel se trouvent les couches de référence, de stockage et de contrôle et, ces conducteurs sont décalés, suivant la direction longitudinale, par rapport à la couche de contrôle et située de part et d'autre de la couche de contrôle. Ces deux conducteurs sont de préférence traversés par des courants électriques qui sont dans des sens opposés l'un de l'autre. Ainsi, ces deux conducteurs permettent de créer un champ magnétique parallèle ou antiparallèle à la direction d'aimantation de la couche de référence.

Selon un autre mode de réalisation, les moyens de contrôle de la direction de l'aimantation dans la couche de contrôle comportent des moyens d'injection, dans la couche de contrôle, d'électrons polarisés parallèlement ou antiparallèlement à la direction de l'aimantation de la couche de référence. Ces moyens d'injection injectent de préférence les électrons dans la couche de contrôle de façon à ce qu'ils traversent la couche de contrôle suivant la direction longitudinale.

En effet, au lieu de modifier la direction d'aimantation de la couche de contrôle grâce à un champ magnétique, on peut aussi modifier cette direction d'aimantation par propagation de paroi induite par courant en utilisant l'effet de transfert de spin. Dans ce cas, la couche de contrôle est une couche conductrice de courant dans laquelle on créé un domaine magnétique qui présente la direction d'aimantation voulue. Ce domaine magnétique est ensuite étendu à l'ensemble de la couche de contrôle en envoyant un courant électrique à travers la couche de contrôle. Les parois du domaine magnétique se propagent alors à travers la couche de contrôle sous l'effet de la pression exercée par le courant d'électrons à cause du transfert de spin.

Plus précisément, selon ce mode de réalisation, on injecte dans une première extrémité de la couche de contrôle un courant d'électrons de spin polarisé. Ce courant d'électrons peut par exemple avoir été polarisé en spin en le faisant passer à travers une couche en matériau magnétique présentant une direction d'aimantation fixe. Les électrons sont alors injectés dans la couche de contrôle en ayant un spin polarisé. Lorsque la couche de contrôle présente une aimantation antiparallèle à la direction du spin des électrons, l'injection du courant d'électrons dans la couche de contrôle permet, par exemple, de nucléer un domaine magnétique dans la couche de contrôle, ce domaine présentant une aimantation parallèle à la direction du spin des électrons. Lorsque les électrons circulent longitudinalement à travers la couche de contrôle, ils repoussent les parois qui délimitent ce domaine, de façon à étendre le domaine à travers la couche de contrôle, si bien que lorsque les électrons atteignent la deuxième extrémité de la couche de contrôle, le domaine s'est étendu à toute la couche de contrôle. L'ensemble de la couche de contrôle présente alors la direction d'aimantation voulue. En choisissant le sens du courant qui parcourt la couche de contrôle, on peut donc contrôler la direction d'aimantation de la couche de contrôle. Ce mode de réalisation permet de changer la direction d'aimantation de la couche de contrôle sans changer la direction d'aimantation de la couche de stockage.

Les moyens d'injection, dans la couche de contrôle, d'électrons polarisés comportent de préférence:
- un empilement disposé au contact d'une première extrémité de la couche de contrôle, cet empilement comportant :
   ∘ un deuxième conducteur ;
   ∘ un matériau antiferromagnétique ;
   ∘ une couche de matériau magnétique ayant une aimantation fixe ;
   ∘ un troisième conducteur ;
- un générateur de courant apte à envoyer un courant électrique de façon à ce qu'il traverse l'empilement dans un sens ou dans le sens opposé ;
- un quatrième conducteur disposé au contact d'une deuxième extrémité de la couche de contrôle.

L'empilement permet de polariser les électrons en spin avant qu'ils soient injectés dans la première extrémité de la couche de contrôle. Les électrons parcourent ensuite la couche de contrôle longitudinalement jusqu'à atteindre le quatrième conducteur.

Selon un mode de réalisation préférentiel, le dispositif magnétique selon l'invention comporte en outre :
- une deuxième couche en matériau antiferromagnétique disposée contre la couche de contrôle ;
- des moyens de contrôle de la température de la deuxième couche en matériau antiferromagnétique.

Ce mode de réalisation permet d'augmenter la stabilité de la couche de contrôle une fois que sa direction d'aimantation a été choisie. En effet, lorsque l'on veut modifier la direction de la couche de contrôle, on chauffe la deuxième couche en matériau antiferromagnétique. La deuxième couche antiferromagnétique devient alors paramagnétique et on peut alors facilement modifier la direction d'aimantation de la couche de contrôle. Par contre, lorsque l'on ne veut pas modifier la direction d'aimantation de la couche de contrôle, on arrête de chauffer la deuxième couche antiferromagnétique, qui piège alors l'aimantation de la couche de contrôle dans la direction où elle est. On peut alors modifier la direction de la couche de stockage, sans risquer de modifier la direction d'aimantation de la couche de contrôle.

Bien que ce mode de réalisation soit compatible avec tous les moyens de contrôle de la direction de l'aimantation de la couche de contrôle, ce mode de réalisation est particulièrement avantageux lorsqu'il est utilisé avec des moyens de contrôle de la direction d'aimantation de la couche de contrôle constitués par des moyens de génération d'un champ magnétique de direction parallèle ou antiparallèle à la direction de l'aimantation de la couche de référence, et en particulier lorsque ces moyens de génération d'un champ magnétique comportent un premier conducteur traversé par un courant électrique. En effet, dans ce cas, les moyens de contrôle de la température de la deuxième couche en matériau antiferromagnétique peuvent comporter par un cinquième conducteur de forte résistance, qui est disposé entre le premier conducteur traversé par le courant électrique qui permet de générer le champ magnétique et la deuxième couche en matériau antiferromagnétique. Lorsque le courant traverse le premier conducteur pour générer un champ magnétique permettant de modifier la direction d'aimantation de la couche de contrôle, ce courant se propage également dans le cinquième conducteur, qu'il chauffe par effet joule. La deuxième couche en matériau antiferromagnétique est alors automatiquement chauffée dès qu'un champ magnétique est créé.

Selon un autre mode de réalisation, on peut également contrôler le chauffage de la deuxième couche en matériau antiferromagnétique indépendamment de la création du champ magnétique en isolant électriquement le premier conducteur et le cinquième conducteur et en faisant passer deux courants différents dans ces deux conducteurs.

Selon différents modes de réalisation :
- la couche de référence, la couche de stockage, la couche de contrôle s'étendent suivant une direction longitudinale, les aimantations de la couche de référence, de la couche de stockage et de la couche de contrôle étant alignées avec la direction longitudinale. Dans ce cas, les aimantations des couches de référence, de stockage et de contrôle sont dites « dans le plan » ;
- la couche de référence, la couche de stockage, la couche de contrôle s'étendent suivant une direction longitudinale, les aimantations de la couche de référence, de la couche de stockage et de la couche de contrôle étant perpendiculaires avec la direction longitudinale. Dans ce cas, les aimantations des couches de référence, de stockage et de contrôle sont dites « hors du plan » ; ce dernier mode de réalisation est particulièrement avantageux car le dispositif magnétique ainsi réalisé présente une stabilité thermique améliorée.

Avantageusement, le dispositif magnétique selon l'invention comporte en outre des moyens d'écriture d'une information dans la couche de stockage aptes à faire circuler un premier courant électrique à travers les couches, dans un sens ou dans le sens opposé.

Avantageusement, le dispositif magnétique selon l'invention comporte en outre :
- des moyens de lecture d'une information contenue dans le couche de stockage aptes à faire circuler un deuxième courant électrique à travers les couches ;
- des moyens de mesure de la tension aux bornes des couches.

Avantageusement, le deuxième courant électrique présente une tension inférieure ou égale à la tension du premier courant électrique.

L'invention concerne également un procédé de lecture d'une information contenue dans un dispositif selon l'invention et un procédé d'écriture d'une information dans un dispositif selon l'invention.

Avantageusement, lorsque la couche de stockage comporte un tricouche antiferromagnétique synthétique formé de deux couches magnétiques séparées par une couche conductrice non magnétique, le procédé d'écriture selon l'invention comporte, préalablement à l'étape de modification de la direction d'aimantation de la couche de stockage, une étape de contrôle de la direction de l'aimantation de la couche de contrôle de façon à ce que la direction d'aimantation de la couche de contrôle soit parallèle à la direction d'aimantation de la couche de référence.

Avantageusement, lorsque la couche de stockage comporte un tricouche antiferromagnétique synthétique formé de deux couches magnétiques séparées par une couche conductrice non magnétique, le procédé de lecture selon l'invention comporte, préalablement à l'étape de lecture de la direction de l'aimantation de la couche de stockage, une étape de contrôle de la direction de l'aimantation de la couche de contrôle de façon à ce que la direction d'aimantation de la couche de contrôle soit antiparallèle à la direction d'aimantation de la couche de référence.

Avantageusement, lorsque la couche de stockage est une monocouche magnétique, le procédé d'écriture selon l'invention comporte, préalablement à l'étape de modification de la direction d'aimantation de la couche de stockage, une étape de contrôle de la direction de l'aimantation de la couche de contrôle de façon à ce que la direction d'aimantation de la couche de contrôle soit antiparallèle à la direction d'aimantation de la couche de référence.

Avantageusement, lorsque la couche de stockage est une monocouche magnétique, le procédé de lecture selon l'invention comporte, préalablement à l'étape de lecture de la direction de l'aimantation de la couche de stockage, une étape de contrôle de la direction de l'aimantation de la couche de contrôle de façon à ce que la direction d'aimantation de la couche de contrôle soit parallèle à la direction d'aimantation de la couche de référence.

D'autres caractéristiques et avantages de l'invention ressortiront à la lecture de la description qui suit, en référence aux figures annexées, qui illustrent :
- la figure 1, une vue en coupe d'un dispositif magnétique selon un mode de réalisation de l'invention en mode écriture ;
- la figure 2, une vue en coupe du dispositif de la figure 1, en mode lecture ;
- la figure 3, une vue en coupe d'un dispositif selon un autre mode de réalisation de l'invention en mode écriture ;
- la figure 4, une vue en coupe du dispositif de la figure 3, en mode lecture ;
- la figure 5, une vue en coupe d'un dispositif selon un autre mode de réalisation de l'invention, en mode lecture ;
- la figure 6, une vue en coupe du dispositif de la figure 5, en mode écriture ;
- la figure 7, une vue en coupe du dispositif de la figure 5 lors de l'écriture d'un « 0 » ;
- la figure 8, une vue en coupe du dispositif de la figure 5, lors de l'écriture d'un « 1 » ;
- la figure 9, une vue en coupe d'un dispositif selon un autre mode de réalisation de l'invention mettant en jeu une écriture de la couche de contrôle assistée thermiquement ;
- la figure 10, une vue en coupe d'un dispositif selon un autre mode de réalisation de l'invention en mode écriture ;
- la figure 11, une vue en coupe d'un dispositif selon un autre mode de réalisation de l'invention, en mode lecture,
- la figure 12, une vue en coupe du dispositif de la figure 11 en mode écriture,
- la figure 13, une vue en coupe d'un dispositif selon un autre mode de réalisation de l'invention en mode lecture.

Pour plus de clarté, les éléments identiques ou similaires sont repérés par des signes de référence identiques sur l'ensemble des figures.

Sur l'ensemble des figures, les flèches désignées par la référence A représentent la direction d'aimantation des différentes couches magnétiques et les flèches désignées par la référence I représentent un courant électrique.

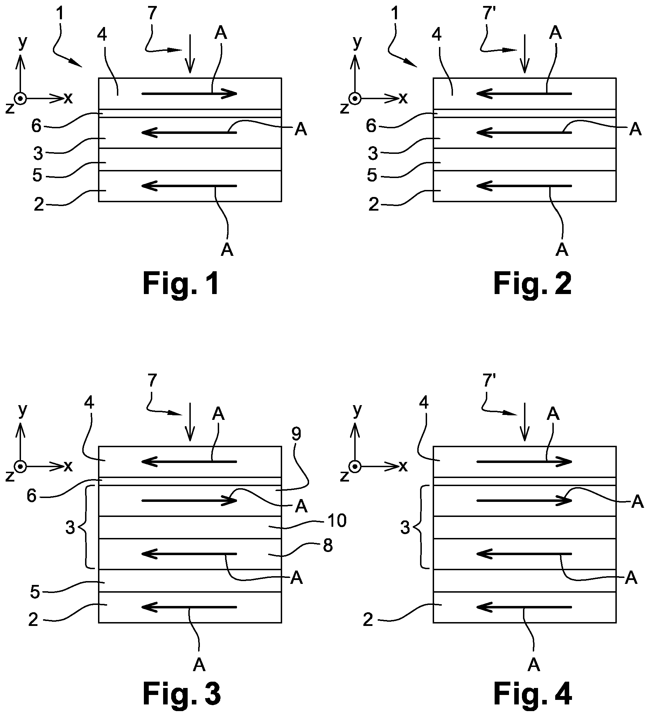

La figure 1 représente un dispositif magnétique 1 selon un mode de réalisation de l'invention. Ce dispositif magnétique 1 comporte :
- une première couche magnétique dite « couche de référence » 2,
- une deuxième couche magnétique dite « couche de stockage » 3,
- une troisième couche magnétique dite « couche de contrôle » 4.

La couche de référence 2 et la couche de stockage 3 sont séparées par un premier espaceur 5. La couche de contrôle 4 et la couche de stockage sont séparées par un deuxième espaceur 6.

Dans ce mode de réalisation, les couches 2 à 6 s'étendent suivant une direction longitudinale 1 parallèle à l'axe x.

Dans tout ce document, on appelle « direction longitudinale » la direction parallèle à l'axe x et « direction transversale » la direction parallèle à l'axe y.

Dans ce mode de réalisation, la couche de référence 2, les couches de stockage 3 et de contrôle 4 présentent des aimantations « dans le plan », c'est-à-dire que les aimantations de ces couches sont dirigées suivant la direction longitudinale.

La couche de référence 2 présente une aimantation de direction fixe, représentée par une flèche sur les figures 1 et 2. La direction d'aimantation de la couche de référence 2 peut par exemple être fixée par couplage d'échange avec une première couche antiferromagnétique. Cette couche de référence 2 peut également être une couche antiferromagnétique synthétique piégée par une couche antiferromagnétique.

Les couches de stockage et de contrôle présentent des aimantations de direction variable : les aimantations de ces couches de stockage 3 et de contrôle 4 peuvent s'orienter soit parallèlement, soit antiparallèlement à la direction d'aimantation de la couche de référence.

La couche de stockage 3 est une monocouche réalisée dans un matériau magnétique, par exemple en alliage Cobalt-Fer-Bore CoFeB. Naturellement, ce matériau magnétique n'est donné qu'à titre d'exemple et on pourrait également envisager de réaliser la couche de stockage 3 dans d'autres matériaux magnétiques, par exemple en CoFe, Fe, ou alliages à base de Ni, de Fe et de Co.

La couche de référence 2 est également une monocouche, qui est par exemple réalisée en CoFeB ou CoFe.

Le premier et le deuxième espaceurs 5, 6 sont réalisés dans une couche isolante ou semi-conductrice, par exemple en MgO ou alumine Al₂O₃.

Le dispositif magnétique 1 peut fonctionner selon un mode écriture et un mode lecture.

En mode écriture, représenté sur la figure 1, l'aimantation de la couche de contrôle 4 est choisie de façon à ce qu'elle soit antiparallèle à la direction d'aimantation de la couche de référence. L'aimantation de la couche de référence est dirigée selon l'axe (-x) et l'aimantation de la couche de contrôle est dirigée selon l'axe (+x).

Lorsque l'on envoie un premier courant d'électrons 7 suivant l'axe (-y) à travers les couches 2 à 6, les électrons de conduction traversent la couche de référence et le spin de ces électrons se polarise à la traversée de cette couche de référence. Les électrons polarisés vont ensuite exercer un couple de transfert de spin sur l'aimantation de la couche de stockage. En outre, les électrons réfléchis par la couche de contrôle 4 qui sont eux polarisés en spin antiparallèlement à l'aimantation de la couche de contrôle, vont aussi exercer un couple de transfert de spin sur l'aimantation de la couche de stockage 3. Le couple de transfert de spin est donc renforcé par l'action conjuguée de la couche de référence 2 et la couche de contrôle 3 puisque ces deux couches présentent des directions d'aimantations antiparallèles. Ce transfert de spin permet de diriger l'aimantation de la couche de stockage soit parallèlement, soit antiparallèlement à la direction d'aimantation de la couche de référence, suivant que le courant d'électrons qui traverse les couches 2 à 6 est dirigé suivant l'axe (-y) ou (+y).

La présence de la couche de contrôle permet donc de faciliter l'écriture d'une information sur la couche de stockage.

En mode lecture, représenté sur la figure 2, l'aimantation de la couche de contrôle 4 est choisie de façon à ce qu'elle soit parallèle à l'aimantation de la couche de référence 2.

Pour lire l'information stockée dans la couche de stockage, on envoie un deuxième courant d'électrons 7' à travers l'empilement des couches 2 à 6, perpendiculairement aux couches 2 à 6. Ce deuxième courant d'électrons 7' permet de mesurer la résistance du dispositif magnétique 1. En effet, lorsque les couches de stockage et de référence présentent des aimantations antiparallèles, la résistance du dispositif est élevée. Au contraire, lorsque les couches de stockage et de référence présentent des aimantations parallèles, la résistance du dispositif est faible. Le deuxième courant d'électrons 7' doit donc permettre de lire l'information contenue dans la couche de stockage sans pour autant modifier cette information.

Pour cela, la couche de référence et la couche de contrôle, qui présentent des aimantations parallèles, exercent des actions opposées sur la couche de stockage puisqu'elles tendent toutes les deux à orienter l'aimantation de la couche de stockage dans des sens opposés. Malgré l'envoi du deuxième courant d'électrons à travers les couches, la direction d'aimantation de la couche de stockage ne varie donc pas.

Le dispositif magnétique selon l'invention permet donc d'envoyer des courants électriques de tension comparable en lecture et en écriture, sans que l'information contenue dans la couche de stockage ne varie en mode lecture.

Les figures 3 et 4 représentent un autre mode de réalisation dans lequel la couche de stockage 3 est constituée d'un empilement tricouche antiferromagnétique synthétique qui comprend deux couches en matériau magnétique 8 et 9 séparées par une couche en matériau conducteur non magnétique 10. Les deux couches en matériau magnétique sont par exemple constituées d'alliage Cobalt-Fer-Bore CoFeB ou CoFe, et la couche en matériau conducteur non magnétique 10 est par exemple constituée de ruthénium Ru d'épaisseur entre 0.5 nm et 0.9 nm.

Les deux couches en matériau magnétique 8 et 9 sont couplées magnétiquement à travers la couche en matériau conducteur non magnétique 10 de sorte que leurs aimantations présentent des directions d'aimantations antiparallèles. Les deux couches en matériau magnétique 8 et 9 présentent de préférence le même moment magnétique, c'est-à-dire le même produit aimantation fois épaisseur, de façon à ce que leurs moments magnétiques soient équilibrés et donc que l'empilement tricouche présente globalement un moment magnétique quasiment nul.

Lorsque la couche de stockage est formée d'un empilement tricouche antiferromagnétique synthétique, on appelle « direction d'aimantation de la couche de stockage » ou « direction de l'aimantation de la couche de stockage », la direction de l'aimantation de la couche magnétique qui appartient à la couche de stockage et qui est située le plus près de la couche de référence.

La couche de référence 2, le premier espaceur 5, la couche de contrôle 4, le deuxième espaceur 6 peuvent être identiques à ceux décrits en référence aux figures 1 et 2.

Dans ce mode de réalisation, en mode écriture, représenté sur la figure 3, la couche de contrôle doit présenter une aimantation parallèle à l'aimantation de la couche de référence. En effet, en mode écriture, lorsqu'un courant électrique traverse l'empilement, la couche de référence 2 tend à orienter l'aimantation de la couche en matériau magnétique 8 dans un sens. Pour favoriser l'écriture, il faut donc que la couche de contrôle 4 tende à orienter l'aimantation de la couche en matériau magnétique 9 dans le sens opposé, puisque les couches en matériau magnétique 8 et 9 sont couplées antiparallèlement.

Au contraire, en mode lecture, représenté sur la figure 4, on veut empêcher que les aimantations des couches en matériau magnétique 8 et 9 changent d'orientation. Pour cela, la couche de contrôle 4 doit présenter une aimantation antiparallèle à la direction d'aimantation de la couche de référence 2. Ainsi, lorsqu'un deuxième courant électrique 7' traverse les couches, la couche de référence tend à orienter l'aimantation de la couche en matériau magnétique 8 dans un sens, et la couche de contrôle tend à orienter l'aimantation de la couche en matériau magnétique 9 dans le même sens, ce qui tend à neutraliser le changement des directions d'aimantations des couches en matériau magnétique 8 et 9 puissent que ces deux couches sont couplées antiparallèlement.

Ainsi, on évite les renversements accidentels de la direction d'aimantation de la couche de stockage lors de la lecture.

Ce mode de réalisation dans lequel la couche de stockage est constituée d'un empilement tricouche est avantageux car l'aimantation de la couche de stockage est plus uniforme. En effet, dans le cas d'une couche de stockage formée par un empilement tricouche, il existe un phénomène de fermeture de flux entre les deux couches magnétiques 8 et 9. En outre, la stabilité thermique de la couche de stockage est augmentée car le volume de la couche de stockage est plus grand.

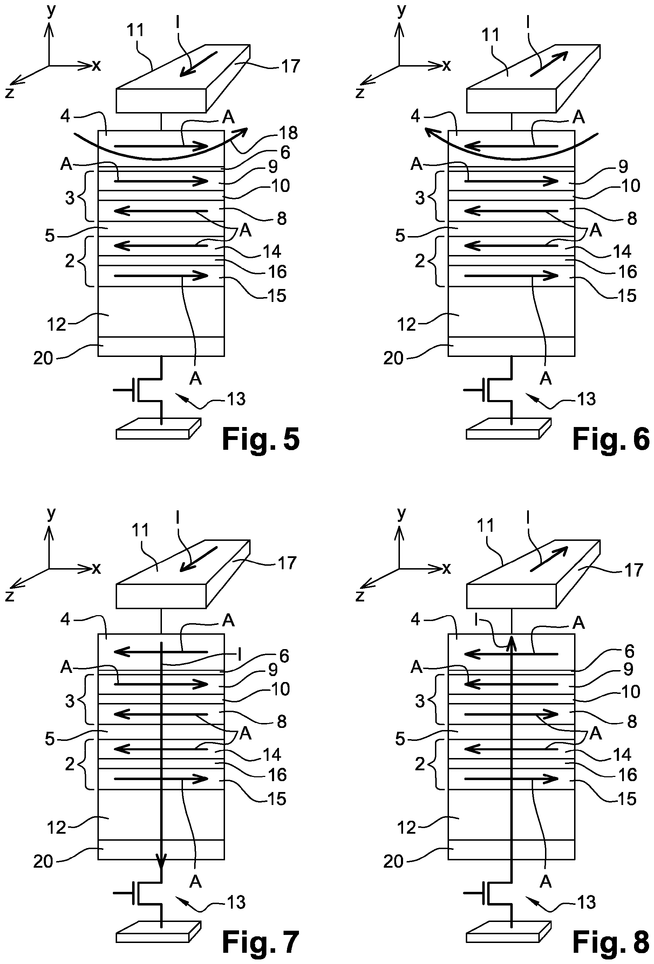

Les figures 5 et 6 représentent un dispositif magnétique selon un autre mode de réalisation dans lequel la couche de stockage 3 est constituée d'un premier empilement tricouche qui comporte deux couches magnétiques 8 et 9 couplées antiparallèlement à travers une couche en matériau conducteur non magnétique 10. Les directions d'aimantation des deux couches magnétiques qui constituent la couche de stockage peuvent varier.

Dans ce mode de réalisation, la couche de référence 2 est également constituée d'un empilement tricouche qui comporte deux couches magnétiques 14 et 15 couplées antiparallèlement à travers une couche conductrice non magnétique 16. Lorsque la couche de référence est constituée d'un empilement tricouche, on appelle « direction d'aimantation ou direction de l'aimantation de la couche de référence » la direction d'aimantation de la couche magnétique de l'empilement tricouche qui se trouve le plus près de la couche de stockage.

Le dispositif magnétique selon ce mode de réalisation comporte en outre une première couche en matériau antiferromagnétique 12, par exemple en alliage Platine Manganèse PtMn d'épaisseur comprise entre 12 nm à 20 nm, disposée contre la couche de référence 2 et destinée à fixer la direction d'aimantation des couches magnétiques 14 et 15 qui constituent la couche de référence 2. La couche de référence 2 peut être un tricouche antiferromagnétique synthétique constitué de deux couches de CoFeB ou CoFe couplées antiparallèlement à travers une fine couche de ruthénium Ru d'épaisseur comprise entre 0.5 nm à 0.9 nm. Une composition typique de cette couche antiferromagnétique synthétique pourrait être une couche de CoFe d'épaisseur 2nm, une couche de ruthénium d'épaisseur 0.6 nm et une couche de CoFeB d'épaisseur 2.5 nm.

Les couches magnétiques 8, 9, 14 et 15 peuvent par exemple être réalisées en alliage Cobalt-Fer-Bore et les couches conductrices non magnétiques 10 et 16 peuvent par exemple être réalisées en ruthénium Ru. Les couches magnétiques 8 et 9 présentent de préférence le même produit aimantation fois épaisseur, de façon à ce que leurs moments magnétiques soient équilibrés. De même les couches magnétiques 14 et 15 présentent de préférence le même produit aimantation fois épaisseur, de façon à ce que leurs moments magnétiques soient équilibrés. Les épaisseurs de chacune de ces couches magnétiques sont typiquement comprises entre 1.5 nm et 4 nm.

La couche de référence pourrait également être formée d'une monocouche magnétique comme dans le mode de réalisation précédent.

La couche de contrôle 4 peut être réalisée en alliage Cobalt-Fer-Bore CoFeB, ou CoFe ou Fe d'épaisseur typiquement comprise entre 4 nm et 8 nm. Les aimantations des couches magnétiques 4, 8, 9, 14 et 15 sont parallèles ou antiparallèles à l'axe x suivant lequel s'étendent ces couches magnétiques 4, 8, 9, 14 et 15.

Le dispositif magnétique comporte en outre un transistor 13.

Le dispositif magnétique comporte également des moyens de contrôle 11 de la direction de l'aimantation de la couche de contrôle 4 aptes à modifier la direction de l'aimantation de la couche de contrôle sans modifier la direction de l'aimantation de la couche de stockage 3. Dans ce mode de réalisation, les moyens de contrôle 11 comportent un conducteur 17 qui s'étend suivant l'axe z et qui est aligné avec la couche de contrôle suivant la direction transversale y. Les moyens de contrôle 11 comportent également des moyens d'envoi (non représentés) d'un courant dans le conducteur 17. Lorsque le conducteur 17 est parcouru par un courant électrique, cela génère un champ magnétique 18, qui peut être parallèle ou antiparallèle à la direction d'aimantation de la couche de référence 2. Ce champ magnétique permet alors d'orienter l'aimantation de la couche de contrôle parallèlement ou antiparallèlement à la direction d'aimantation de la couche de référence.

Dans ce mode de réalisation, le champ magnétique n'a pas d'influence significative sur l'orientation de l'aimantation des couches magnétiques 8 et 9 qui constituent la couche de stockage puisque les moments magnétiques des couches magnétiques 8 et 9 sont compensés [ou proches d'être compensés]. En effet, les deux couches magnétiques 8 et 9, qui sont couplées antiparallèlement, présentent des moments magnétiques opposés, de sorte que le moment magnétique global de la couche de stockage est quasiment nul. Le champ magnétique créé par les moyens de contrôle 11 n'a donc pas d'influence sur la couche de stockage. Par contre, il permet de modifier la direction d'aimantation de la couche de contrôle, qui n'est couplée magnétique à aucune autre couche.

Ainsi, préalablement à la lecture de l'information contenue dans la couche de stockage (figure 5), on envoie un courant électrique suivant l'axe +z à travers le conducteur 17. Ce courant électrique créé un champ magnétique antiparallèle à l'aimantation de la couche 14 de la couche de référence, ce qui provoque l'alignement de l'aimantation de la couche de contrôle antiparallèlement à la direction d'aimantation de la couche à travers les couches de référence, de stockage et de contrôle de façon à lire l'information contenue dans la couche de stockage, le transfert de spin créé par la couche de contrôle et le transfert de spin créé par la couche de référence se compensent, ce qui permet de limiter les risques de changement de direction d'aimantation des couches 8 et 9 qui constituent la couche de stockage.

Au contraire, préalablement à la modification de l'information contenue dans la couche de stockage (figure 6) c'est-à-dire à une écriture de l'information dans la couche de stockage, on envoie un courant électrique suivant l'axe -z à travers le conducteur 17 de façon à créer un champ magnétique qui provoque l'alignement de l'aimantation de la couche de contrôle parallèlement à l'aimantation de la couche magnétique 14 de la couche de référence 2.

La figure 7 représente ensuite le procédé d'écriture d'un « 0 » dans la couche de stockage. Pour cela, on envoie un courant électrique à travers les couches de référence, de stockage et de contrôle de façon à ce que ce courant électrique traverse les couches perpendiculairement aux couches. Le courant doit être envoyé suivant l'axe (-y). La couche de référence 2, et plus précisément la couche magnétique 14 de la couche de référence 2, tend alors à orienter l'aimantation de la couche magnétique 8 parallèlement à la direction d'aimantation de la couche magnétique 14. La couche de contrôle 4 tend elle à orienter l'aimantation de la couche magnétique 9 antiparallèlement à la direction d'aimantation de la couche de contrôle. Les couches de référence et de contrôle coopèrent donc de façon à orienter la direction d'aimantation de la couche de stockage dans le même sens. Au cours de ce procédé d'écriture, il est important que la couche de contrôle ne commute pas sous l'effet du couple de transfert de spin exercé par les autres couches magnétiques sur l'aimantation de la couche de contrôle. Pour cela, il suffit de choisir une épaisseur de la couche de contrôle suffisante, typiquement au-delà de 4 nm pour que l'aimantation de la couche de contrôle puisse résister à au couple de transfert de spin qui permet de modifier la direction d'aimantation de la couche de stockage. En effet, il est connu que le couple de transfert de spin est essentiellement interfacial. La densité de courant critique nécessaire au basculement de l'aimantation de la couche de contrôle varie donc proportionnellement à l'épaisseur de la couche. En augmentant l'épaisseur de la couche de contrôle, on minimise ainsi l'impact sur la couche de contrôle du couple de transfert de spin sans pour autant rendre plus difficile sa commutation par champ puisque le champ appliqué agit sur tout le volume de la couche.

La figure 8 représente le procédé d'écriture d'un « 1 » dans la couche de stockage. Pour cela, on envoie un courant électrique à travers les couches de référence, de stockage et de contrôle de façon à ce courant électrique traverse les couches perpendiculairement aux couches. Le courant doit être envoyé suivant l'axe (+y). La couche de référence 2, et plus précisément la couche magnétique 14 de la couche de référence 2, tend alors à orienter l'aimantation de la couche magnétique 8 antiparallèlement à la direction d'aimantation de la couche magnétique 14. La couche de contrôle tend elle à orienter l'aimantation de la couche magnétique 9 parallèlement à la direction d'aimantation de la couche de contrôle. Les couches de référence et de contrôle coopèrent donc de façon à orienter la direction d'aimantation de la couche de stockage dans le même sens.

Dans ce mode de réalisation, le conducteur 17 permet à la fois :
- de conduire le courant qui permet de créer le champ magnétique permettant de modifier la direction d'aimantation de la couche de contrôle et
- d'amener le courant électrique qui traversent les couches de référence 2, de contrôle 4 et de stockage 3 afin de lire ou d'écrire une information dans la couche de référence.

Toutefois, on pourrait également envisager d'utiliser deux conducteurs séparés pour effectuer ces deux fonctions.

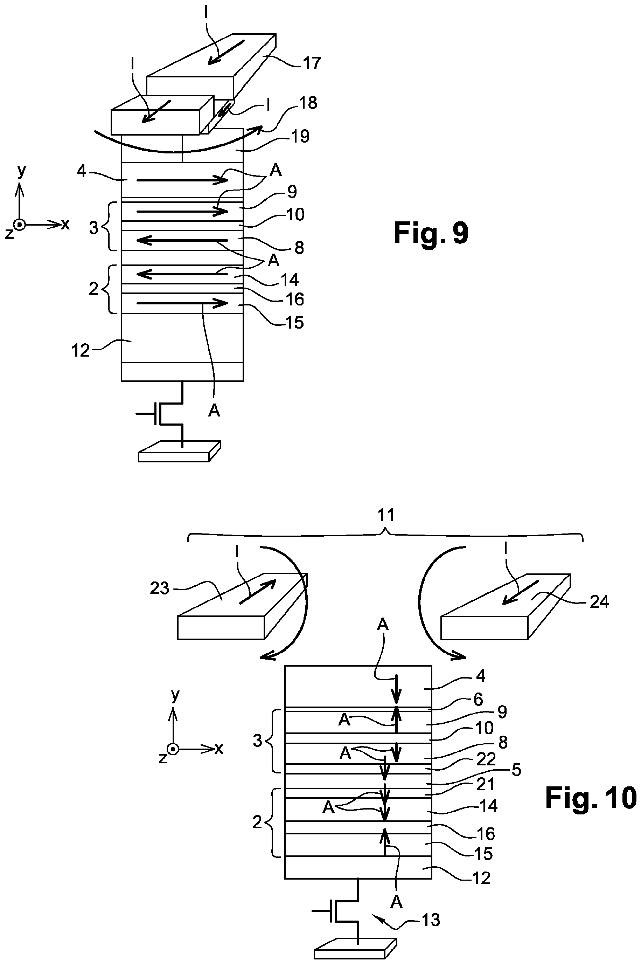

La figure 9 représente un dispositif magnétique selon un autre mode de réalisation. Dans ce mode de réalisation, le dispositif magnétique est semblable à celui décrit en référence aux figures 5 à 8, à l'exception du fait qu'il comporte en outre, entre le premier conducteur 17 et la couche de contrôle 4 :
- un cinquième conducteur 18 qui produit de la chaleur lorsqu'il est traversé par un courant électrique. Ce cinquième conducteur 18 est par exemple constitué de tantale ou de tungstène, ou encore peut être constitué du même matériau que le conducteur 17 mais d'épaisseur plus fine pour présenter localement une résistance par unité de longueur plus élevée ; et
- une deuxième couche antiferromagnétique 19 en contact avec la couche de contrôle 4 et le cinquième conducteur 18.

Selon ce mode de réalisation, le cinquième conducteur 18 est en contact avec le premier conducteur 17 de sorte que lorsqu'un courant traverse le premier conducteur 17, il traverse également le cinquième conducteur 18.

En l'absence de courant à travers le cinquième conducteur 18, la direction d'aimantation de la couche de contrôle est figée par la présence de la deuxième couche en matériau ferromagnétique 19. La direction d'aimantation de la couche de contrôle peut soit être figée parallèlement à la direction d'aimantation de la couche magnétique 14 de la couche de référence, soit antiparallèlement à cette direction d'aimantation. Ainsi, on peut modifier la direction d'aimantation de la couche de stockage sans modifier la direction d'aimantation de la couche de contrôle.

Par contre, lorsqu'un courant traverse le premier conducteur 17 afin de créer un champ magnétique en vue de modifier la direction d'aimantation de la couche de contrôle, ce courant se propage également dans le cinquième conducteur 18. Le cinquième conducteur 18 produit alors de la chaleur par effet joule et il chauffe la deuxième couche en matériau antiferromagnétique, de sorte que cette deuxième couche en matériau antiferromagnétique devient paramagnétique et que la direction d'aimantation de la couche de contrôle peut varier sous l'effet du champ magnétique créer par le passage du courant dans le conducteur 17.

Lorsque l'on coupe le courant, la deuxième couche en matériau antiferromagnétique redevient antiferromagnétique et fige la direction d'aimantation de la couche de contrôle.

On pourrait également utiliser un premier conducteur 17 et un cinquième conducteur 18 qui ne sont pas en contact, de façon à pouvoir commander indépendamment le chauffage de la deuxième couche en matériau antiferromagnétique et la création du champ magnétique par le premier conducteur 17.

On pourrait également envisager de chauffer la deuxième couche antiferromagnétique par d'autres moyens de chauffage externes.

La couche antiferromagnétique 19 peut être en FeMn ou IrMn ou IrMnCr avec une température de blocage typiquement comprise entre 180 et 250°C.

En outre, la couche de référence pourrait être constituée d'une seule monocouche au lieu d'être formée d'un empilement tricouche.

De même, la couche de stockage pourrait être formée d'une monocouche au lieu d'être formée d'un empilement tricouche antiferromagnétique synthétique. Dans ce cas, la couche de stockage doit présenter une coercitivité plus forte que la coercitivité de la couche de contrôle afin que la direction d'aimantation de la couche de stockage ne varie lorsque l'on modifie la direction d'aimantation de la couche de contrôle. On pourrait par exemple utiliser un alliage cobalt-chrome pour réaliser la couche de stockage et une couche en alliage Cobalt-Fer-Bore pour la couche de contrôle.

La figure 10 représente un autre mode de réalisation dans lequel les couches magnétiques du dispositif magnétique présentent des aimantations hors du plan. Ainsi, ce dispositif magnétique comporte une couche de référence 2 qui comporte un empilement tricouche qui comporte lui-même une première couche magnétique 14, une deuxième couche magnétique 15, la première et la deuxième couches magnétiques 14 et 15 étant séparées par une couche conductrice non magnétique 16 assurant un couplage antiparallèle entre les couches 14 et 15. La première et la deuxième couches magnétiques 14 et 15 peuvent être constituées d'une multicouche ou d'un alliage Cobalt-Palladium Co/Pd, d'une multicouche ou d'un alliage Cobalt-Platine, ou encore d'une multicouche ou d'un alliage Cobalt-Nickel ou d'un alliage Terre Rare/Métaux de transition (TbFe par exemple). La couche conductrice non magnétique 16 qui sépare la première et la deuxième couches magnétiques peut par exemple être constituée de ruthénium d'épaisseur comprise entre 0.5 nm et 0.9 nm.

Le dispositif magnétique comporte également une couche de stockage 3, qui comporte, dans le cas présent, un empilement tricouche antiferromagnétique synthétique qui comporte lui-même une première et une deuxième couches magnétiques 8 et 9 séparées par une couche conductrice non magnétique 10 assurant un couplage antiparallèle entre les couches 8 et 9. La première et la deuxième couches magnétiques 8 et 9 peuvent être constituées d'une multicouche ou d'un alliage Cobalt-Palladium Co/Pd, d'une multicouche ou d'un alliage Cobalt-Platine ou encore d'une multicouche ou d'un alliage Cobalt-Nickel. La couche conductrice non magnétique 10 qui sépare la première et la deuxième couches magnétiques peut par exemple être constituée de ruthénium d'épaisseur comprise entre 0.5 nm et 0.9 nm.

Le dispositif magnétique comporte également une couche de contrôle 4, par exemple constituée de CoFeB.

Le dispositif magnétique présente une orientation hors du plan, c'est-à-dire que les couches de référence 2, de stockage 3 et de contrôle s'étendent suivant la direction longitudinale x, tandis que les aimantations des couches magnétiques 8, 9, 14, 15 s'étendent suivant la direction transversale y ou -y. Ce dispositif magnétique à aimantation hors du plan est particulièrement avantageux car il présente une stabilité thermique améliorée par rapport aux dispositifs magnétiques à aimantation dans le plan. En effet, les matériaux à aimantation hors du plan présentent une anisotropie d'origine interfaciale qui est supérieure que celle des matériaux à aimantation dans le plan.

Le dispositif magnétique comporte également un premier espaceur 5 et un deuxième espaceur 6, respectivement situé entre la couche de référence et la couche de stockage, et entre la couche de stockage et la couche de contrôle. Les deux espaceurs peuvent par exemple être constitués de MgO ou d'alumine.

Le dispositif magnétique comporte également une couche tampon 12 qui permet de promouvoir une bonne croissance de l'ensemble de la structure. Cette couche tampon peut être par exemple en Ta, en Pt, en CuN.

Le dispositif magnétique comporte également un transistor 13.

Selon ce mode de réalisation, la couche de référence 2 comporte également de préférence une première couche de transition 21 qui est située entre l'empilement tricouche 14-15-16 et le premier espaceur 5. Cette couche de transition 21 présente préférentiellement une structure cristallographique cubique centrée lorsque l'espaceur 5 est une barrière tunnel de MgO. Cette couche de transition 21 est par exemple constituée de CoFeB qui cristallise sous forme cubique centrée au contact de MgO par recuit vers 250°C-350°C. En effet, les couches 14-15-16 qui constituent la couche de référence présentent une structure cristallographique cubique face centrée ou hexagonale, tandis que le premier espaceur 5, en MgO, présente une structure cristallographie cubique centrée. La couche de transition 21 forme donc une transition structurelle entre la couche de référence 2 et le premier espaceur 5, ce qui permet d'augmenter la magnétorésistance au niveau du premier espaceur 5.

De même, la couche de stockage 3 comporte de préférence une deuxième couche de transition 22, qui est située contre le premier espaceur 5. Cette deuxième couche de transition 22 présente une structure cristallographique cubique centrée et elle permet de réaliser une transition structurelle entre l'empilement tricouche de la couche de stockage qui présente une structure cristallographique cubique face centré ou hexagonal et le premier espaceur 5 qui présente une structure cristallographique cubique centré. Cette couche de transition 22 est par exemple constituée de CoFeB.

Chaque couche de transition 21, 22 doit présenter une aimantation qui est parallèle à l'aimantation de la couche magnétique, respectivement 14, 8 contre laquelle elle se trouve. Cette orientation est en particulier acquise par l'interaction d'échange entre l'aimantation de ces couches de transition et l'aimantation des couches magnétiques avec lesquelles elles sont respectivement en contact.

De même, on pourrait également réaliser la couche de référence et la couche de stockage dans une monocouche, au lieu de les réaliser dans des empilements tricouches.

Le dispositif magnétique comporte également des moyens de contrôle 11 de la direction de l'aimantation de la couche de contrôle aptes à modifier la direction de l'aimantation de la couche de contrôle sans modifier la direction de l'aimantation de la couche de stockage. La couche de contrôle 4 présente une direction d'aimantation qui est parallèle ou antiparallèle à l'axe y et par conséquent les moyens de contrôle 11 sont aptes à créer un champ magnétique qui est parallèle ou antiparallèle à l'axe y. Pour cela, les moyens de contrôle 11 comportent par exemple au moins deux conducteurs de courant 23 et 24 qui s'étendent suivant l'axe z et qui sont décalés transversalement par rapport à la couche de contrôle 4. Les conducteurs de courant 23 et 24 sont donc situés de part et d'autre de la couche de contrôle 4 lorsque l'on se déplace suivant l'axe x. Les deux conducteurs 23 et 24 sont parcourus par des courants I qui parcourent chacun des conducteurs en sens inverse l'un de l'autre. Les moyens de contrôle 11 pourraient également comporter un seul conducteur décalé suivant l'axe x par rapport à la couche de contrôle.

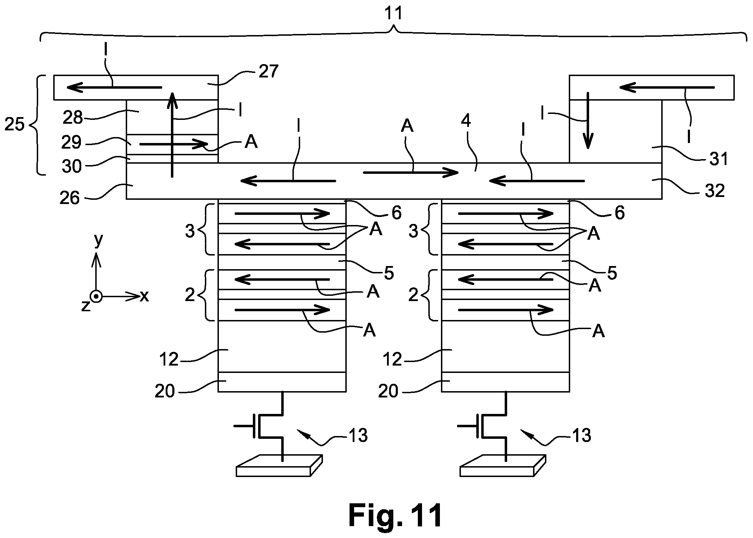

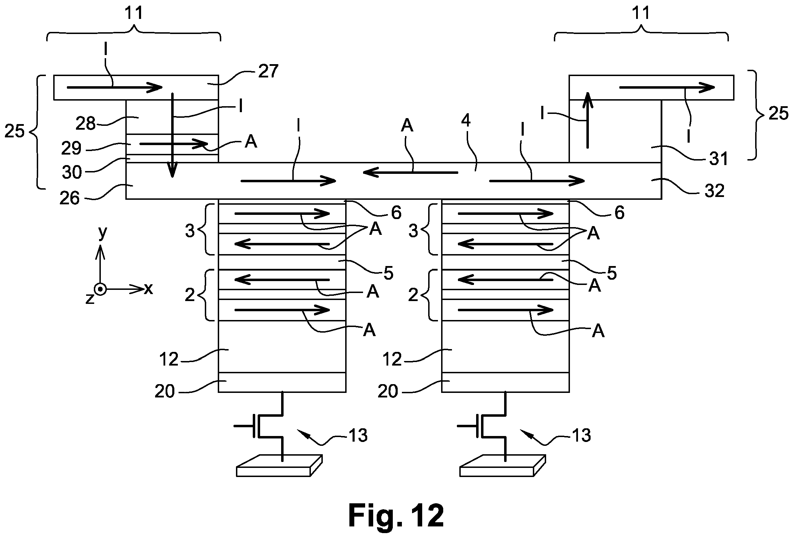

Les figures 11 et 12 représentent un autre mode de réalisation dans lequel les moyens de contrôle 11 permettent de modifier la direction d'aimantation de la couche de contrôle par propagation longitudinale de paroi. Les figures 11 et 12 représentent deux dispositifs magnétiques selon l'invention qui présentent une couche de contrôle 4 commune aux deux dispositifs magnétiques, mais on pourrait également réaliser des dispositifs magnétiques qui comportent chacun leur propre couche de contrôle sans sortir du cadre de l'invention. Chacun de ces deux dispositifs magnétiques comporte une couche de référence 2, une couche de stockage 3 et deux espaceurs 5 et 6 semblables à ceux décrits en référence aux figures 5 à 9, mais on pourrait également envisager de remplacer les empilements tricouches par des monocouches sans sortir du cadre de l'invention. La couche de contrôle 4 s'étend suivant la direction longitudinale x. Les moyens de contrôle 11 comportent des moyens d'injection 25, dans la couche de contrôle 4, d'électrons polarisés parallèlement ou antiparallèlement à la direction de l'aimantation de la couche de référence. Ces moyens d'injection 25 comportent un empilement disposé au contact d'une première extrémité 26 de la couche de contrôle 4. Cet empilement comporte :
- un deuxième conducteur 27, par exemple du cuivre;
- un matériau antiferromagnétique 28;
- une couche de matériau magnétique ayant une aimantation fixe 29, par exemple une couche de CoFe;
- un troisième conducteur 30, par exemple du cuivre.

Les moyens d'injection 11 comportent également un générateur de courant (non représenté) apte à envoyer un courant électrique de façon à ce qu'il traverse l'empilement transversalement dans un sens ou dans le sens opposé.

Les moyens d'injection 25 comportent également un quatrième conducteur 31 disposé au contact d'une deuxième extrémité 32 de la couche de contrôle 4.

Les moyens d'injection 25 sont donc aptes à faire circuler longitudinalement, à travers la couche de contrôle, un courant d'électrons polarisé en spin parallèlement ou antiparallèlement à la direction longitudinale.

La couche de contrôle est une ligne conductrice magnétique et on envoie, longitudinalement, à travers cette couche de contrôle un courant électrique I qui est polarisé en spin. Pour cela, les électrons traversent la couche de matériau magnétique ayant une aimantation fixe 29, dont la direction d'aimantation est piégée par le matériau antiferromagnétique 28. La couche de matériau magnétique ayant une aimantation fixe 29 doit présenter une direction d'aimantation parallèle ou antiparallèle à la direction d'aimantation de la couche de référence. Lorsque les électrons sont injectés dans la première extrémité 26 de la couche de contrôle, ils sont donc polarisés en spin. Ces électrons vont nucléer un domaine dans la première extrémité de la couche de contrôle, ce domaine présentant une aimantation de polarisation voulue. Lorsque le courant I se propage longitudinalement à travers la couche de contrôle, les parois de ce domaine sont repoussées à travers toute la couche de contrôle jusqu'à ce que ces parois atteignent la deuxième extrémité 32 de la couche de contrôle et alors l'ensemble de la couche de contrôle présente l'aimantation voulue. Pour changer la direction d'aimantation de la couche de contrôle, il suffit de modifier le sens de propagation du courant I à travers la couche de contrôle.

Les conducteurs 27, 30 et 31 permettent de favoriser la circulation du courant électrique à travers la couche de contrôle 4.

La figure 11 représente donc le dispositif magnétique en mode lecture, tandis que la figure 12 représente le même dispositif magnétique en mode écriture.

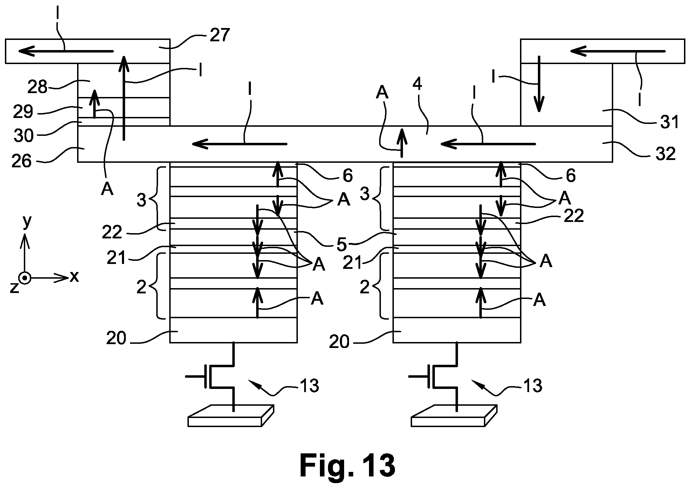

La figure 13 représente un dispositif magnétique analogue à celui des figures 11 et 12 à l'exception du fait qu'il présente une aimantation hors du plan. Chaque dispositif magnétique comporte deux couches de transition 21, 22 comme celles décrites en référence à la figure 10.

Dans le cas d'une aimantation hors du plan, comme la couche de matériau magnétique ayant une aimantation fixe 29 doit présenter une direction d'aimantation parallèle ou antiparallèle à la direction d'aimantation de la couche de référence, la couche de matériau magnétique ayant une aimantation fixe 29 doit également présenter une aimantation hors du plan.

Naturellement, l'invention n'est pas limitée aux modes de réalisation décrits en référence aux figures et des variantes peuvent être envisagées sans sortir du cadre de l'invention ainsi que définie par les revendications. En particulier, les matériaux choisis pour réaliser la couche de référence, la couche de stockage et la couche de contrôle ne sont donnés qu'à titre illustratif et d'autres matériaux pourraient être utilisés.

## Revendications

1. Dispositif magnétique comprenant :
- une première couche magnétique dite « couche de référence » (2) ayant une aimantation de direction fixe ;
- une deuxième couche magnétique dite « couche de stockage » (3) ayant une aimantation de direction variable, l'aimantation de la couche de stockage (3) pouvant s'orienter soit parallèlement soit antiparallèlement à l'aimantation de la couche de référence (2) ;
- un premier espaceur (5) séparant la couche de référence (2) et la couche de stockage (3),
**caractérisé en ce que** le dispositif comporte en outre :
- une troisième couche magnétique dite « couche de contrôle » (4) ayant une aimantation de direction variable de façon à faire passer le dispositif magnétique d'un mode lecture à un mode écriture et inversement, l'aimantation de la couche de contrôle (4) étant, préalablement à toute lecture ou écriture, contrôlée de façon à ce que :
∘ en mode lecture, la couche de contrôle présente une direction d'aimantation respectivement parallèle ou antiparallèle à la direction d'aimantation de la couche de référence selon le type de la couche de stockage (respectivement monocouche ou tricouche) de façon à soustraire les couples de transfert de spin exercés par la couche de référence et la couche de contrôle sur l'aimantation de la couche de stockage ;
∘ en mode écriture, la couche de contrôle présente une direction d'aimantation :
▪ parallèle à la direction d'aimantation de la couche de référence lorsque la couche de contrôle présente une direction d'aimantation antiparallèle à la direction d'aimantation de la couche de référence en mode lecture, ou
▪ antiparallèle à la direction d'aimantation de la couche de référence lorsque la couche de contrôle présente une direction d'aimantation parallèle à la direction d'aimantation de la couche de référence en mode lecture ;
- un deuxième espaceur (6) séparant la couche de stockage (3) et la couche de contrôle (4),
- des moyens de contrôle (11) de la direction de l'aimantation de la couche de contrôle (4) aptes à modifier la direction de l'aimantation de la couche de contrôle (4) sans modifier la direction de l'aimantation de la couche de stockage (3).

2. Dispositif magnétique selon la revendication précédente, **caractérisé en ce que** la couche de stockage (3) présente une coercitivité supérieure à la coercitivité de la couche de contrôle (4).

3. Dispositif selon l'une quelconque des revendications précédentes, **caractérisé en ce que** la couche de stockage (3) est formée d'un premier empilement tri-couche dit « antiferromagnétique synthétique » constitué de deux couches magnétiques (8, 9) séparées par une couche conductrice non magnétique (10), les deux couches magnétiques étant couplées antiparallèlement à travers la couche conductrice non magnétique.

4. Dispositif magnétique selon l'une quelconque des revendications 1 ou 2, caractérisé en ce la couche de stockage (3) est formée d'une monocouche en matériau magnétique.

5. Dispositif magnétique selon la revendication 3, **caractérisé en ce que** les moyens de contrôle (11) de la direction de l'aimantation de la couche de contrôle (11) comportent des moyens de génération d'un champ magnétique de direction parallèle ou antiparallèle à la direction de l'aimantation de la couche de référence (2).

6. Dispositif selon l'une quelconque des revendications 1 à 4, **caractérisé en ce que** les moyens de contrôle (11) de la direction de l'aimantation dans la couche de contrôle comportent des moyens d'injection (25), dans la couche de contrôle, d'électrons polarisés parallèlement ou antiparallèlement à la direction de l'aimantation de la couche de référence (2).

7. Dispositif selon la revendication précédente, **caractérisé en ce que** les moyens d'injection (25), dans la couche de contrôle (4), d'électrons polarisés comportent :
- un empilement disposé au contact d'une première extrémité (26) de la couche de contrôle (4), cet empilement comportant :
∘ un deuxième conducteur (27);
∘ un matériau antiferromagnétique (28);
∘ une couche de matériau magnétique ayant une aimantation fixe (29);
∘ un troisième conducteur (30);
- un générateur de courant apte à envoyer un courant électrique de façon à ce qu'il traverse l'empilement dans un sens ou dans le sens opposé ;
- un quatrième conducteur (31) disposé au contact d'une deuxième extrémité (32) de la couche de contrôle (4).

8. Dispositif magnétique selon l'une quelconque des revendications précédentes, **caractérisé en ce qu'**il comporte en outre :
- une couche en matériau antiferromagnétique (19) disposée contre la couche de contrôle (4),
- des moyens de contrôle (18) de la température de la couche en matériau antiferromagnétique (19).

9. Dispositif magnétique selon l'une quelconque des revendications précédentes, **caractérisé en ce que** la couche de référence (2), la couche de stockage (3), la couche de contrôle (4) s'étendent suivant une direction longitudinale, les aimantations de la couche de référence (2), de la couche de stockage (3) et de la couche de contrôle (4) étant alignées avec la direction longitudinale.

10. Dispositif magnétique selon l'une quelconque des revendications 1 à 8, **caractérisé en ce que** la couche de référence (2), la couche de stockage (3), la couche de contrôle (4) s'étendent suivant une direction longitudinale, les aimantations de la couche de référence (2), de la couche de stockage (3) et de la couche de contrôle (4) étant perpendiculaires à la direction longitudinale.

11. Dispositif magnétique selon l'une quelconque des revendications précédentes, **caractérisé en ce qu'**il comporte en outre des moyens d'écriture d'une information dans la couche de stockage aptes à faire circuler un premier courant électrique (7) à travers les couches, dans un sens ou dans le sens opposé.

12. Dispositif magnétique selon l'une quelconque des revendications précédentes, **caractérisé en ce qu'**il comporte en outre :
- des moyens de lecture d'une information contenue dans le couche de stockage aptes à faire circuler un deuxième courant électrique (7') à travers les couches ;
- des moyens de mesure de la tension aux bornes des couches.

13. Procédé de modification de la direction de l'aimantation de la couche de stockage du dispositif magnétique selon l'une quelconque des revendications 3 ou 5 à 10 lorsqu'elles dépendent de la revendication 3, **caractérisé en ce que**, préalablement à l'étape de modification de la direction d'aimantation de la couche de stockage (3), la direction de l'aimantation de la couche de contrôle (4) est contrôlée de façon à ce qu'elle soit parallèle à la direction d'aimantation de la couche de référence (2).

14. Procédé de lecture de la direction de l'aimantation de la couche de stockage du dispositif magnétique selon l'une quelconque des revendications 3 ou 5 à 10 lorsqu'elles dépendent de la revendication 3, **caractérisé en ce que**, préalablement à l'étape de lecture de la direction de l'aimantation de la couche de stockage (3), la direction de l'aimantation de la couche de contrôle (4) est contrôlée de façon à ce qu'elle soit antiparallèle à la direction d'aimantation de la couche de référence (2).

15. Procédé de modification de la direction de l'aimantation de la couche de stockage du dispositif magnétique de la revendication 4 ou de l'une quelconque des revendications 6 à 10 lorsqu'elles dépendent de la revendication 4, **caractérisé en ce que**, préalablement à l'étape de modification de la direction d'aimantation de la couche de stockage (3), la direction de l'aimantation de la couche de contrôle (4) est contrôlée de façon à ce qu'elle soit antiparallèle à la direction d'aimantation de la couche de référence (2).

16. Procédé de lecture de la direction de l'aimantation de la couche de stockage du dispositif magnétique de la revendication 4 ou de l'une quelconque des revendications 6 à 10 lorsqu'elles dépendent de la revendication 4, **caractérisé en ce que**, préalablement à l'étape de lecture de la direction de l'aimantation de la couche de stockage (3), la direction de l'aimantation de la couche de contrôle (4) est contrôlée de façon à ce qu'elle soit parallèle à la direction d'aimantation de la couche de référence (2).

## Patentansprüche

1. Magnetische Vorrichtung, umfassend:
- eine erste magnetische Schicht, bezeichnet als "Referenzschicht" (2) mit einer festen Magnetisierungsrichtung;
- eine zweite magnetische Schicht, bezeichnet als "Speicherschicht" (3) mit einer Magnetisierung mit variabler Richtung, wobei die Magnetisierung der Speicherschicht (3) sich entweder parallel oder antiparallel zur Magnetisierung der Referenzschicht (2) ausrichten kann;
- einen ersten Abstandshalter (5), der die Referenzschicht (2) und die Speicherschicht (3) voneinander trennt,
**dadurch gekennzeichnet, dass** die Vorrichtung darüber hinaus umfasst:
- eine dritte Magnetschicht, bezeichnet als "Kontrollschicht" (4) mit einer Magnetisierung mit variabler Richtung derart, dass die magnetische Vorrichtung von einem Lesemodus in einen Schreibmodus und umgekehrt umgeschaltet wird, wobei die Magnetisierung der Kontrollschicht (4) vor jedem Lesen oder Schreiben derart kontrolliert ist, dass:
∘ die Kontrollschicht im Lesemodus eine zur Magnetisierungsrichtung der Referenzschicht jeweils parallele oder antiparallele Magnetisierungsrichtung gemäß dem Typ der Speicherschicht (jeweils einschichtig oder dreischichtig) derart aufweist, dass die von der Referenzschicht und der Kontrollschicht auf die Magnetisierung der Speicherschicht ausgeübten Spin-Übertragungsmomente abgezogen werden;
∘ die Kontrollschicht im Schreibmodus eine Magnetisierungsrichtung aufweist:
▪ parallel zur Magnetisierungsrichtung der Referenzschicht, wenn die Kontrollschicht eine zur Magnetisierungsrichtung der Referenzschicht antiparallele Magnetisierungsschicht im Lesemodus aufweist oder
▪ antiparallel zur Magnetisierungsrichtung der Referenzschicht, wenn die Kontrollschicht eine zur Magnetisierungsrichtung der Referenzschicht parallele Magnetisierungsschicht im Lesemodus aufweist oder
- einen zweiten Abstandshalter (6), der die Speicherschicht (3) und die Kontrollschicht (4) trennt,
- Kontrollmittel (11) der Richtung der Magnetisierung der Kontrollschicht (4), die geeignet sind, die Richtung der Magnetisierung der Kontrollschicht (4) ohne Modifizieren der Richtung der Magnetisierung der Speicherschicht (3) zu modifizieren.

2. Magnetische Vorrichtung gemäß dem voranstehenden Anspruch, **dadurch gekennzeichnet, dass** die Speicherschicht (3) eine höhere Koerzivität aufweist als die Koerzivität der Kontrollschicht (4).

3. Vorrichtung gemäß irgendeinem der voranstehenden Ansprüche, **dadurch gekennzeichnet, dass** die Speicherschicht (3) aus einer ersten dreischichtigen, als "synthetische antiferromagnetische" bezeichnete Stapelung geformt ist, die aus zwei magnetischen Schichten (8, 9) gebildet ist, die durch eine nicht magnetische leitende Schicht (10) getrennt sind, wobei die zwei magnetischen Schichten antiparallel durch die nicht magnetische leitende Schicht gekoppelt sind.

4. Magnetische Vorrichtung gemäß irgendeinem der Ansprüche 1 oder 2, **dadurch gekennzeichnet, dass** die Speicherschicht (3) aus einer Monoschicht aus magnetischem Material geformt ist.

5. Magnetische Vorrichtung gemäß Anspruch 3, **dadurch gekennzeichnet, dass** die Steuermittel (11) der Richtung der Magnetisierung der Kontrollschicht (11) Erzeugungsmittel eines Magnetfeldes zur Richtung der Magnetisierung der Referenzschicht (2) paralleler oder antiparalleler Richtung umfassen.

6. Vorrichtung gemäß irgendeinem der Ansprüche 1 bis 4, **dadurch gekennzeichnet, dass** die Kontrollmittel (11) der Richtung der Magnetisierung in der Kontrollschicht Einspritzmittel (25), in der Kontrollschicht zur Richtung der Magnetisierung der Referenzschicht (2) parallel oder antiparallel polarisierte Elektronen umfassen.

7. Vorrichtung gemäß dem voranstehenden Anspruch, **dadurch gekennzeichnet, dass** die Einspritzmittel (25) in der Kontrollschicht (4) polarisierte Elektronen umfassen:
- eine Stapelung, die im Kontakt mit einem ersten Ende (26) der Kontrollschicht (4) angeordnet ist, wobei diese Stapelung umfasst:
∘ einen zweiten Leiter (27);
∘ ein antiferromagnetisches Material (28);
∘ eine Schicht aus magnetischem Material mit einer festen Magnetisierung (29);
∘ einen dritten Leiter (30);
- einen Stromerzeuger, der geeignet ist, einen elektrischen Strom derart zu versenden, dass er die Stapelung in einer oder in der entgegengesetzten Richtung durchquert;
- einen vierten Leiter (31), der im Kontakt mit einem zweiten Ende (32) der Kontrollschicht (4) angeordnet ist.

8. Magnetische Vorrichtung gemäß irgendeinem der voranstehenden Ansprüche, **dadurch gekennzeichnet, dass** sie darüber hinaus umfasst:
- eine Schicht aus einem antiferromagnetischen Material (19), die gegen die Kontrollschicht (4) angeordnet ist,
- Kontrollmittel (18) der Temperatur der Schicht aus antiferromagnetischem Material (19).

9. Magnetische Vorrichtung gemäß irgendeinem der voranstehenden Ansprüche, **dadurch gekennzeichnet, dass** die Referenzschicht (2), die Speicherschicht (3), die Kontrollschicht (4) sich gemäß einer Längsrichtung erstrecken, wobei die Magnetisierungen der Referenzschicht (2), der Speicherschicht (3) und der Kontrollschicht (4) mit der Längsrichtung gefluchtet sind.

10. Magnetische Vorrichtung gemäß irgendeinem der Ansprüche 1 bis 8, **dadurch gekennzeichnet, dass** die Referenzschicht (2), die Speicherschicht (3), die Kontrollschicht (4) sich gemäß einer Längsrichtung erstrecken, wobei die Magnetisierungen der Referenzschicht (2), der Speicherschicht (3) und der Kontrollschicht (4) lotrecht zur Längsrichtung sind.

11. Magnetische Vorrichtung gemäß irgendeinem der voranstehenden Ansprüche, **dadurch gekennzeichnet, dass** sie darüber hinaus Schreibmittel einer Information in der Speicherschicht umfasst, die geeignet sind, einen ersten elektrischen Strom (7) durch die Schichten in einer Richtung oder in der entgegengesetzten Richtung fließen zu lassen.

12. Magnetische Vorrichtung gemäß irgendeinem der voranstehenden Ansprüche, **dadurch gekennzeichnet, dass** sie darüber hinaus umfasst:
- Lesemittel einer in der Speicherschicht enthaltenen Information, die geeignet sind, einen zweiten elektrischen Strom (7') durch die Schichten fließen zu lassen;
- Messmittel der Spannung an den Anschlüssen der Schichten.

13. Modifizierungsverfahren der Richtung der Magnetisierung der Speicherschicht der magnetischen Vorrichtung gemäß irgendeinem der Ansprüche 3 oder 5 bis 10, wenn sie von Anspruch 3 abhängen, **dadurch gekennzeichnet, dass**, die Richtung der Magnetisierung der Kontrollschichte (4) vor dem Modifizierungsschritt der Magnetisierungsrichtung der Speicherschicht (3) derart kontrolliert ist, dass sie parallel zur Magnetisierungsrichtung der Referenzschicht (2) ist.

14. Leseverfahren der Richtung der Magnetisierung der Speicherschicht der magnetischen Vorrichtung gemäß irgendeinem der Ansprüche 3 oder 5 bis 10, wenn sie von Anspruch 3 abhängen, **dadurch gekennzeichnet, dass** die Richtung der Magnetisierung der Kontrollschicht (4) vor dem Leseschritt der Richtung der Magnetisierung der Speicherschicht (3) derart kontrolliert ist, dass sie antiparallel zur Magnetisierungsrichtung der Referenzschicht (2) ist.

15. Modifizierungsverfahren der Richtung der Magnetisierung der Speicherschicht de magnetischen Vorrichtung des Anspruchs 4 oder irgendeinem der Ansprüche 6 bis 10, wenn sie von Anspruch 4 abhängen, **dadurch gekennzeichnet, dass** die Richtung der Magnetisierung der Kontrollschicht (4) vor dem Modifizierungsschritt der Magnetisierungsrichtung der Speicherschicht (3) derart kontrolliert ist, dass sie antiparallel zur Magnetisierungsrichtung der Referenzschicht (2) ist.

16. Leseverfahren der Richtung der Magnetisierung der Speicherschicht der magnetischen Vorrichtung des Anspruchs 4 oder irgendeines der Ansprüche 6 bis 10, wenn sie von Anspruch 4 abhängen, **dadurch gekennzeichnet, dass** die Richtung der Magnetisierung der Kontrollschicht (4) vor dem Leseschritt der Richtung der Magnetisierung der Speicherschicht (3) derart kontrolliert ist, dass sie parallel zur Magnetisierungsrichtung der Referenzschicht (2) ist.

## Claims

1. A magnetic device comprising:
- a first magnetic layer called a "reference layer" (2) having a fixed direction magnetisation;
- a second magnetic layer called a "storage layer" (3) having a variable direction magnetisation, wherein the magnetisation of the storage layer (3) is orientable either in parallel or in anti-parallel to the magnetisation of the reference layer (2);
- a first spacer (5) separating the reference layer (2) from the storage layer (3),
**characterised in that** the device further includes:
- a third magnetic layer called a "control layer" (4) having a variable direction magnetisation so as to switch the magnetic device from a reading mode to a writing mode and reversely, the magnetisation of the control layer (4) being, prior to any reading or writing, controlled such that:
∘ in reading mode, the control layer has a magnetisation direction respectively parallel or anti-parallel to the magnetisation direction of the reference layer depending on the type of the storage layer (respectively single layer or trilayer) so as to subtract the spin transfer torques exerted by the reference layer and the control layer on the magnetisation of the storage layer;
∘ in writing mode, the control layer has a magnetisation direction:
▪ parallel to the magnetisation direction of the reference layer when the control layer has a magnetisation direction anti-parallel to the magnetisation direction of the reference layer in reading mode, or
▪ anti-parallel to the magnetisation direction of the reference layer when the control layer has a magnetisation direction parallel to the magnetisation direction of the reference layer in reading mode;
- a second spacer (6) separating the storage layer (3) from the control layer (4),
- means (11) for controlling the magnetisation direction of the control layer (4) able to modify the magnetisation direction of the control layer (4) without modifying the magnetisation direction of the storage layer (3).

2. The magnetic device according to the preceding claim, **characterised in that** the storage layer (3) has a coercivity higher than the coercivity of the control layer (4).

3. The device according to any of the preceding claims, **characterised in that** the storage layer (3) is formed by a first trilayer stack called "synthetic anti-ferromagnetic" consisting of two magnetic layers (8, 9) separated by a non-magnetic conductive layer (10), both magnetic layers being coupled in anti-parallel through the non-magnetic conductive layer.

4. The magnetic device according to any of claims 1 and 2, **characterised in that** the storage layer (3) is formed by a single layer of magnetic material.

5. The magnetic device according to claim 3, **characterised in that** the means (11) for controlling the magnetisation direction of the control layer (11) include means for generating a magnetic field with a direction parallel or anti-parallel to the magnetisation direction of the reference layer (2).

6. The device according to any of claims 1 to 4, **characterised in that** the means (11) for controlling the magnetisation direction in the control layer include means (25) for injecting, in the control layer, electrons polarised in parallel or anti-parallel to the magnetisation direction of the reference layer (2).

7. The device according to the preceding claim, **characterised in that** the means (25) for injecting, in the control layer (4), polarised electrons include:
- a stack contacting a first end (26) of the control layer (4), this stack including:
∘ a second conductor (27);
∘ an anti-ferromagnetic material (28);
∘ a layer of magnetic material having a fixed magnetisation (29);
∘ a third conductor (30);
- a current generator able to send an electric current such that it passes through the stack in one direction or in the opposite direction;
- a fourth conductor (31) contacting a second end (32) of the control layer (4).

8. The magnetic device according to any of the preceding claims, **characterised in that** it further includes:
- a layer of anti-ferromagnetic material (19) disposed against the control layer (4),
- means (18) for controlling the temperature of the layer of anti-ferromagnetic material (19).

9. The magnetic device according to any of the preceding claims, **characterised in that** the reference layer (2), the storage layer (3), the control layer (4) extend along a longitudinal direction, the magnetisations of the reference layer (2), of the storage layer (3) and of the control layer (4) being aligned with the longitudinal direction.

10. The magnetic device according to any of claims 1 to 8, **characterised in that** the reference layer (2), the storage layer (3), the control layer (4) extend along a longitudinal direction, the magnetisations of the reference layer (2), of the storage layer (3) and of the control layer (4) being perpendicular to the longitudinal direction.

11. The magnetic device according to any of the preceding claims, **characterised in that** it further includes means for writing a piece of information in the storage layer, which means are able to flow a first electric current (7) through the layers, in one direction or in the opposite direction.

12. The magnetic device according to any of the preceding claims, **characterised in that** it further includes:
- means for reading a piece of information contained in the storage layer, which means are able to flow a second electric current (7') through the layers;
- means for measuring the voltage across the layers.

13. A method for modifying the magnetisation direction of the storage layer of the magnetic device according to any of claims 3 or 5 to 10 when dependent on claim 3, **characterised in that**, prior to the step of modifying the magnetisation direction of the storage layer (3), the magnetisation direction of the control layer (4) is controlled such that it is parallel to the magnetisation direction of the reference layer (2).

14. A method for reading the magnetisation direction of the storage layer of the magnetic device according to any of claims 3 or 5 to 10 when dependent on claim 3, **characterised in that**, prior to the step of reading the magnetisation direction of the storage layer (3), the magnetisation direction of the control layer (4) is controlled such that it is anti-parallel to the magnetisation direction of the reference layer (2).

15. A method for modifying the magnetisation direction of the storage layer of the magnetic device of claim 4 or of any of claims 6 to 10 when dependent on claim 4, **characterised in that**, prior to the step of modifying the magnetisation direction of the storage layer (3), the magnetisation direction of the control layer (4) is controlled such that it is anti-parallel to the magnetisation direction of the reference layer (2).

16. A method for reading the magnetisation direction of the storage layer of the magnetic device of claim 4 or of any of claims 6 to 10 when dependent on claim 4, **characterised in that**, prior to the step of reading the magnetisation direction of the storage layer (3), the magnetisation direction of the control layer (4) is controlled such that it is parallel to the magnetisation direction of the reference layer (2).
